# EUROPÄISCHE PATENTSCHRIFT

(11) **EP 3 689 104 B1**
(45) Veröffentlichungstag und Bekanntmachung des Hinweises auf die Patenterteilung: **08.07.2026**
(21) Anmeldenummer: 18782312.5
(22) Anmeldetag: 12.09.2018
(51) Int. Cl.: H05B 3/48, B33Y 80/00, H05B 3/28

(54) **HOCHTEMPERATURBAUTEIL UND VERFAHREN ZUR HERSTELLUNG**
HIGH-TEMPERATURE COMPONENT AND METHOD OF MANUFACTURING
ÉLÉMENT À HAUTE TEMPÉRATURE ET PROCÉDÉ DE FABRICATION

(30) Priorität: 26.09.2017 DE 102017217122
(43) Veröffentlichungstag der Anmeldung: 05.08.2020
(73) Patentinhaber: Schunk Kohlenstofftechnik GmbH, 35452 Heuchelheim (DE)
(72) Erfinder: NAUDITT, Gotthard, 35625 Huettenberg (DE)
(74) Vertreter: advotec.
(86) Internationale Anmeldenummer: PCT/EP2018/074557
(87) Internationale Veröffentlichungsnummer: WO 2019/063285

(56) Entgegenhaltungen:
- EP-A1- 2 987 779
- EP-A2- 2 520 839
- DE-A1- 102011 006 850
- US-A1- 2011 174 803

## Beschreibung

Die Erfindung betrifft ein Verfahren zur Herstellung eines Widerstandsheizelementes sowie ein Widerstandsheizelement, wobei ein formstabiler Grünkörper des Widerstandsheizelementes aus einem Matrixmaterial ausgebildet wird, wobei der Grünkörper mittels einer Pyrolyse des Matrixmaterials zu dem Widerstandsheizelement ausgebildet wird, wobei zur Ausbildung des Widerstandsheizelementes eine Materialmischung des Matrixmaterials mit einem Kohlenstoffmaterial verwendet wird.

Hochtemperaturbauteile und insbesondere Widerstandsheizelemente werden regelmäßig als Heizelemente für eine thermische Analyse in sogenannten DSC-Öfen eingesetzt (dynamische Differenzkalorimetrieöfen). Die bekannten Widerstandsheizelemente sind daher rohrförmig und einstückig ausgebildet und werden an ihrer Unterseite an einer Anode und einer Kathode bzw. Anschlussflächen kontaktiert. Eine Wandung des Widerstandsheizelements ist mit zwei Schlitzen versehen, die spiralförmig ausgebildet sind und so Heizwendeln des Widerstandsheizelements bzw. einen Heizleiter ausbilden. Im Bereich der Heizwendeln des Widerstandsheizelements wird eine Temperatur von bis zu 1.650 °C erreicht. Dabei soll ein Glühbild möglichst homogen über den Bereich der Heizwendeln verteilt sein. Weiter ist eine hohe Reinheit des Materials des Widerstandsheizelements von großer Wichtigkeit, da beispielsweise bei einer Reinheitsbestimmung von Proben im DSC-Ofen unerwünschte Zusatzstoffe aus dem Widerstandsheizelement herausdiffundieren und eine Messung verfälschen könnten.

Bei einem bekannten Verfahren zur Herstellung eines Hochtemperaturbauteils bzw. eines Widerstandsheizelements wird beispielsweise ein Materialrohling aus einem Faserwerkstoff mittels Harz formstabilisiert und mit abschließender Pyrolyse sowie einer Infiltration von Silizium, um ein Widerstandsheizelement aus Siliziumcarbid zu erhalten, ausgebildet. Weiter ist es bekannt, einen zylindrischen Formkörper zur Ausbildung eines Widerstandsheizelements durch ein Schlickerverfahren auszubilden. Dabei muss, um eine gewünschte Heizwendelstruktur zu erhalten, ein im Schlickerverfahren ausgebildeter Grünkörper bzw. ein zylindrischer Formkörper bearbeitet werden. Eine geringe Festigkeit des Grünkörpers schränkt dabei, wie auch bei dem aus Faserwerkstoff ausgebildeten Widerstandsheizelement, die Bearbeitungsmöglichkeiten erheblich ein und hat eine hohe Anzahl von Fehlteilen durch Bruch infolge von Bearbeitung und Handhabung im Rahmen des jeweiligen Herstellungsverfahrens zur Folge. Auch können sich Risse durch insbesondere eine inhomogene Verteilung von Materialien in dem Widerstandheizelement während eines Betriebs ergeben.

Weiter ist es bekannt, Widerstandsheizelemente bzw. einen Grünkörper eines Widerstandsheizelements durch schichtweisen Aufbau einer Siliziumcarbid oder Silizium und Kohlenstoff enthaltenden Pulver-Harzmischung herzustellen. Durch eine Pyrolyse des Grünkörpers kann dann eine Stützmatrix aus Siliziumcarbid ausgebildet werden, die zum Teil mit Kohlenstoff gefüllt oder nachfolgend in weiteren Prozessschritten mit einem Kohlenstoff enthaltenden Material aufgefüllt wird, um einen Widerstand des Widerstandsheizelements einzustellen. Auch hier ist der aus der Pulvermischung mit einem Binder bzw. Harz bestehende Grünkörper sehr fragil und es sind nachfolgend der Pyrolyse eine Reihe weiterer Prozessschritte erforderlich, beispielsweise eine Infiltration des Widerstandsheizelements mit Kohlenstoff durchzuführen.

Weiterhin offenbart die EP 2 987 779 A1 gemäß ihrer Zusammenfassung ein Verfahren zur Herstellung eines Formkörpers sowie einen Formkörper mit einer Siliziumcarbid-Stützmatrix und einer integralen Kohlenstoffstruktur, wobei ein Basiskörper auf Basis einer Siliziumcarbid oder Silizium und Kohlenstoff enthaltenden Pulvermischung und eines Binders in einem generativen Verfahren schichtweise aufgebaut wird, und zur Ausbildung des Formkörpers nach Aushärtung des Binders eine Pyrolyse des Basiskörpers erfolgt, wobei der Kohlenstoffgehalt der Kohlenstoffstruktur durch die Pyrolyse des Binders und den Kohlenstoffgehalt der Pulvermischung oder Infiltration eines Kohlenstoffmaterials in die Siliziumcarbid-Stützmatrix eingestellt wird.

Ferner offenbart die DE 10 2011 006850 A1 gemäß ihrer Zusammenfassung ein Verfahren zur Herstellung eines Widerstandsheizelements sowie ein Widerstandsheizelement, wobei das Widerstandsheizelement eine rohrförmige Gestalt aufweist, wobei das Widerstandsheizelement einstückig ausgebildet ist, wobei das Widerstandsheizelement aus Siliziumcarbid gebildet ist.

Der vorliegenden Erfindung liegt daher die Aufgabe zugrunde, ein Verfahren zur Herstellung eines Hochtemperaturbauteils bzw. ein Widerstandsheizelement vorzuschlagen, welches eine effiziente Herstellung ermöglicht.

Diese Aufgabe wird durch ein Verfahren mit den Merkmalen des Anspruchs 1 gelöst. Ferner wird die Aufgabe durch ein Widerstandsheizelement gelöst, das nach dem erfindungsgemäßen Verfahren hergestellt ist..

Bei dem erfindungsgemäßen Verfahren zur Herstellung eines Widerstandsheizelements wird ein formstabiler Grünkörper des Widerstandsheizelementes aus einem Matrixmaterial ausgebildet, wobei als Matrixmaterial ein Thermoplast verwendet wird, wobei das Widerstandsheizelement einstückig und mit einem Heizleiter und mit einem den Heizleiter aufnehmenden elektrisch nichtleitenden Leiterträger ausgebildet wird, wobei der Heizleiter aus einer Materialmischung des Matrixmaterials mit einem Kohlenstoffmaterial und der Leiterträger aus einer weiteren Materialmischung des Matrixmaterials mit einem Siliziummaterial ausgebildet, und wobei der Grünkörper durch ein additiven Fertigungsverfahren aus der Materialmischung und gleichzeitig der weiteren Materialmischung ausgebildet und nachfolgend mittels einer Pyrolyse zu dem Widerstandsheizelement ausgebildet wird.

Mit dem Verfahren ist es prinzipiell möglich, jede beliebige Form eines Hochtemperaturbauteils auszubilden. Unter einem Hochtemperaturbauteil wird hier ein Bauteil verstanden, dass bei einer Temperatur aus einem Bereich von 300 °C bis 3.000 °C nutzbar ist. Dadurch, dass ein Thermoplast verwendet wird, kann beim schichtweisen Aufbau des Grünkörpers besonders gut sichergestellt werden, dass die jeweiligen Schichten, anders bei einer Pulvermischung mit einem Harz oder dergleichen, fest aneinanderhaften, wodurch ein besonders stabiler Grünkörper erhalten wird. Dieser Grünkörper kann einfach gehandhabt werden, ohne dass ein schneller Bruch des Grünkörpers zu befürchten wäre. Weiter kann bei der nachfolgenden Pyrolyse des Grünkörpers in einem Ofen der Thermoplast zu einem großen Teil in Kohlenstoff umgewandelt werden. Zusammen mit dem Kohlenstoffmaterial, welches dem Thermoplast zugesetzt wurde, kann dann ein Hochtemperaturbauteil erhalten werden, welches eine geringe Porosität und damit einen hohen Kohlenstoffanteil aufweist. Eine vergleichsweise hohe Füllung des Thermoplastes mit dem Kohlenstoffmaterial bewirkt einen geringen elektrischen Widerstand sowie eine reduzierte Schwindung und dadurch eine bessere Stabilität des Hochtemperaturbauteils während der Pyrolyse. Insgesamt kann so eine Anzahl möglicher Ausschussteile bei der Herstellung des Hochtemperaturbauteils wesentlich gesenkt werden.

Besonders vorteilhaft ist es, wenn das Hochtemperaturbauteil einstückig ausgebildet wird. Dadurch entfällt eine Montage von mehreren Bauteilen zu dem Hochtemperaturbauteil und das Hochtemperaturbauteil wird insgesamt einfacher herstellbar. Bei einer einstückigen Ausbildung des Hochtemperaturbauteils kann der Grünkörper dann ebenfalls einstückig ausgebildet werden.

Erfindungsgemäß ist das Hochtemperaturbauteil als Widerstandsheizelement ausgebildet, wobei das Widerstandsheizelement mit einem Heizleiter ausgebildet werden kann. Der Heizleiter des Widerstandsheizelements, aus dem auch das gesamte Widerstandsheizelement ausgebildet sein kann, kann aus dem Thermoplast, dem ein Kohlenstoffmaterial zugesetzt ist, durch das additive Fertigungsverfahren schichtweise aufgebaut und so in seiner Form ausgebildet werden. Zusammen mit dem Kohlenstoffmaterial, welches dem Thermoplast zugesetzt wurde, kann dann ein Heizleiter erhalten werden, der eine geringe Porosität und damit einem hohen Kohlenstoffanteil aufweist. Mit dem Verfahren ist es prinzipiell möglich, jede beliebige Form eines Widerstandsheizelements auszubilden. Das Verfahren eignet sich jedoch besonders zur Ausbildung von Widerstandsheizelementen mit einer komplexen Geometrie sowie auch flachen bzw. ebenen Widerstandsheizelementen mit vergleichsweise filigranen Heizleitern, da diese Widerstandsheizelemente bei den aus dem Stand der Technik bekannten Herstellungsverfahren leicht zerstört werden können.

Das Widerstandsheizelement kann mit einem den Heizer aufnehmenden elektrisch nichtleitenden Leiterträger ausgebildet werden. Der Leiterträger kann dann dielektrische oder Halbleitereigenschaften (>10⁴ S/cm) aufweisen. Dadurch, dass der Leiterträger den Heizleiter aufnehmen kann, kann der Heizleiter an dem Leiterträger angeordnet, in diesem eingebettet oder von dem Leiterträger allseitig umschlossen ausgebildet werden. Dies wird erst dadurch möglich, dass der Grünkörper mittels des additiven Fertigungsverfahrens ausgebildet wird. Der Heizleiter kann dann besonders filigran ausgebildet werden, da der Heizleiter dann von dem Leiterträger gestützt wird. Auch wenn der Leiterträger im Wesentlichen nichtleitend bzw. halbleitend ausgebildet wird, erübrigt sich eine Ausbildung von Luftspalte im Material des Grünkörpers bzw. des Widerstandsheizelements und damit eine mechanische Bearbeitung, die vielfach Ursache für einen Bruch des Grünkörpers bzw. des Widerstandsheizelements sein kann. Auch kann durch das Fehlen von Luftspalten zwischen Heizleiterbahnen eine Temperaturverteilung bzw. ein Glühbild des Widerstandsheizelements homogener gestaltet und damit verbessert werden. Der Leiterträger kann eine möglichst geringe elektrische Leitfähigkeit aufweisen, sodass ein Stromfluss zwischen Leiterbahnen des Heizleiters vermieden wird. Prinzipiell ist es jedoch nach wie vor möglich, einen Luftspalt zwischen Leiterbahnen des Heizleiters auszubilden, wenn dies vorteilhaft erscheint.

Zur Ausbildung des Leiterträgers kann eine weitere Materialmischung des Matrixmaterials mit einem Siliziummaterial verwendet werden. Dadurch wird es möglich, mittels des additiven Fertigungsverfahrens die Materialmischung zusammen mit der weiteren Materialmischung aufgrund des übereinstimmenden Matrixmaterials einfach und stabil miteinander zu verbinden. Bei einem schichtweisen Aufbau des Grünkörpers besteht dann der Grünkörper vollständig aus dem Matrixmaterial, wobei dann das Kohlenstoffmaterial und das Siliziummaterial je nach Ausbildung des Heizleiters und des Leiterträgers während des schichtweisen Aufbaus ausgegeben werden.

Der Grünkörper kann mit der in der weiteren Materialmischung eingebetteten Materialmischung ausgebildet werden. Demnach kann der Heizleiter im Wesentlichen innerhalb des Leiterträgers angeordnet sein. Der Leiterträger umgibt dann den Heizleiter vollständig, wodurch der Heizleiter vor Oxidation und mechanischen Beschädigungen geschützt werden kann. Zum Anschluss des Widerstandsheizelements kann vorgesehen sein, dass an dem Widerstandsheizelement Anschlussflächen des Heizleiters ausgebildet werden, die aus dem Leiterträger heraustreten bzw. nicht von dem Leiterträger bedeckt werden. Das Einbetten der Materialmischung in der weiteren Materialmischung wird erst durch die Anwendung des additiven Fertigungsverfahrens möglich.

Die weitere Materialmischung kann mit einer stöchiometrischen Mischung von Matrixmaterial und Siliziummaterial verwendet werden, wobei dann bei der Pyrolyse aus der weiteren Materialmischung Siliziumcarbid gebildet werden kann. Da das Matrixmaterial ein Thermoplast ist, der bei der Pyrolyse in Kohlenstoff umgewandelt wird, kann durch die Mischung mit dem Siliziummaterial bei der Pyrolyse Siliziumcarbid ausgebildet werden. Um einen Überschuss an freiem Silizium oder Kohlenstoff in den Leiterträger zu vermeiden, wird dann die stöchiometrische Mischung von Matrixmaterial und Siliziummaterial verwendet. Zur Bildung von Siliziumcarbid wird ein Masseverhältnis von Kohlenstoff zu Silizium von 1:2,33 benötigt. Dabei ist zu berücksichtigen, welche Masse an Kohlenstoff bei der Pyrolyse des Thermoplastes gewonnen werden kann. Die stöchiometrische Mischung ist daher immer auch von der Auswahl des Matrixmaterials abhängig. Wenn reines Siliziumcarbid ausgebildet werden kann, wird eine besonders scharfe Trennung von Heizleiter und Leiterträger möglich. Darüber hinaus wird eine geringe elektrische Leitfähigkeit des Leiterträgers ausgebildet und ein Herausdiffundieren von freiem Silizium aus dem Leiterträger kann vermieden werden.

Somit kann mittels der Pyrolyse die Materialmischung des Heizleiters in Kohlenstoff und die weitere Materialmischung des Leiterträgers in Siliziumcarbid umgewandelt werden. Auch kann durch die Füllung des Matrixmaterials bzw. Thermoplastes mit Kohlenstoffmaterial oder Siliziummaterial eine hohe Dichte des Widerstandsheizelements bei gleichzeitig einer geringen Porosität erzielt werden. Als Siliziummaterial können beispielsweise Siliziumfasern oder Siliziumpartikel verwendet werden. Durch die Verwendung von Siliziumfasern wird es möglich, den Grünkörper bereits sehr stabil auszubilden. Auch werden durch die Siliziumfasern bei nachfolgenden Verfahrensschritten eventuelle Risse in dem Grünkörper bzw. Widerstandsheizelement vermieden.

Als Kohlenstoffmaterial können Kohlenstofffasern, Ruß, Graphit, Graphen und/oder Kohlenstoffnanoröhren verwendet werden. Insbesondere durch die ausschließliche Verwendung oder teilweise Beimischung von Graphen kann eine Leitfähigkeit des Heizleiters gegenüber Graphit wesentlich verbessert werden. Weiter bewirkt ein hoher Anteil von Kohlenstoff im Thermoplast eine reduzierte Schwindung des Heizleiters während der Pyrolyse. Neben Kohlenstofffasern können jedoch auch andere organische Fasern verwendet werden, die im Rahmen einer Pyrolyse in Kohlenstoff umgewandelt werden können. Auch verbessern die Kohlenstofffasern die Festigkeitseigenschaften des Grünkörpers bzw. des Hochtemperaturbauteils bzw. Widerstandsheizelements.

Die Fasern können vorzugsweise Kurzschnittfasern sein und zusammen mit dem Matrixmaterial aus einer Düse ausgegeben und räumlich angeordnet werden. Wenn die Fasern zusammen mit dem Matrixmaterial bzw. dem Thermoplast aus der Düse extrudiert werden, kann der Grünkörper dann ohne Zuhilfenahme einer Form ausgebildet werden. Die Fasern werden zusammen mit dem Thermoplast auf der Basis eines Datenmodells einer Gestalt des Grünkörpers bzw. eines Heizleiters und eines Leiterträgers von der Düse schichtweise abgelegt. Dabei kann vorgesehen sein, dass dies mit einer Düse für die Materialmischung und einer weiteren Düse für die weitere Materialmischung erfolgt. Die Düse wird dann entlang der Gestalt des Grünkörpers während des Extrudierens bewegt, sodass der Grünkörper durch Auftragen der Fasern mit dem Thermoplast generativ aufgebaut wird. Es wird dann möglich, ein Faserverbundbauteil bzw. einen Grünkörper mit einer nahezu beliebigen Gestalt auszubilden. Die Verwendung einer Form zur Ausbildung der Gestalt ist dann nicht erforderlich, wodurch der Grünkörper insgesamt auch kostengünstiger herstellbar wird. Die Faser kann einen Durchmesser von 5 µm bis 30 µm, vorzugsweise von 10 µm, aufweisen. Fasern mit diesen Durchmessern eignen sich besonders gut für eine Extrusion aus der Düse zusammen mit dem Thermoplast.

Besonders vorteilhaft ist es, wenn das Hochtemperaturbauteil bzw. Widerstandsheizelement mit einem Faseranteil von 10 Vol.% bis 60 Vol.%, vorzugsweise von bis zu 35 Vol.%, ausgebildet werden kann. Ein hoher Faseranteil begünstigt die Festigkeitseigenschaften des Grünkörpers bzw. des Widerstandsheizelements.

Der Grünkörper kann mittels Schmelzschichtung (FDM, Fused Deposition Modeling) ausgebildet werden. Bei der Schmelzschichtung wird mit einem sogenannten 3D-Drucker ein Raster von Punkten auf eine Fläche aufgetragen. Dabei wird dem 3D-Drucker ein drahtförmiger Thermoplast zugeführt, erwärmt und über eine Düse extrudiert, wobei anschließend der Thermoplast durch Abkühlung in der gewünschten Position erhärtet. Der Aufbau des Grünkörpers erfolgt dann durch zeilenweises Abfahren der jeweiligen Schichten mit der Düse, sodass eine Gestalt des Grünkörpers schichtweise entsteht. Eine Schichtdicke kann zwischen 0,025 mm und 1,25 mm betragen.

Als Matrixmaterial kann Polyetherimid (PEI), Polyetheretherketon (PEEK), Polysulfon (PSU) oder Polyphenylensulfon (PPSU) verwendet werden. Diese Kunststoffe eignen sich zur Verwendung mittels eines additiven Fertigungsverfahrens und es kann ein hoher Anteil an Kohlenstoff bei einer Pyrolyse dieser Kunststoffe gewonnen werden, beispielsweise bei PEI 55 Masse% und bei PEEK 50 Masse% Kohlenstoff.

Nach der Pyrolyse kann eine CVD-Beschichtung des Hochtemperaturbauteil bzw. Widerstandsheizelements mit Siliziumcarbid erfolgen. So kann ein Austritt freien Siliziums während eines Betriebs eines Widerstandsheizelements verhindert werden. Bei der CVD-Beschichtung (Chemische Gasphasenabschneidung) wird bei beispielsweise 700 °C bis 1.500 °C eine Siliziumcarbidschicht auf das Hochtemperaturbauteil bzw. Widerstandsheizelement aufgebracht. Die Siliziumcarbidschicht umgibt das Hochtemperaturbauteil bzw. Widerstandsheizelement im Wesentlichen vollständig, sodass eventuell im Material des Hochtemperaturbauteils bzw. Widerstandsheizelements eingeschlossenes Silizium nicht aus diesem austreten kann.

Nach der Pyrolyse kann eine Hochtemperaturbehandlung des Hochtemperaturbauteils bzw. Widerstandsheizelements erfolgen. Die Pyrolyse kann in einem Temperaturbereich von 280 °C bis 1.200 °C und die Hochtemperaturbehandlung in einem Temperaturbereich von 1.200 °C bis 2.400 °C durchgeführt werden. Die Hochtemperaturbehandlung kann unter anderem zum Abbau von Sauerstoff und Stickstoff im Hochtemperaturbauteil bzw. Widerstandsheizelement dienen und unter Vakuum oder Schutzgas durchgeführt werden.

Das erfindungsgemäße Widerstandsheizelement ist einstückig ausgebildet, wobei das Widerstandsheizelement mit einem Heizleiter aus Kohlenstoff ausgebildet ist, wobei das Widerstandsheizelement mit einem den Heizleiter aufnehmenden elektrisch nichtleitenden Leiterträger aus Siliziumcarbid ausgebildet ist. Unter einem nichtleitenden Leiterträger wird hier ein Leiterträger mit einer elektrischen Leitfähigkeit von zumindest >10⁴ S/cm verstanden. Insbesondere dadurch, dass der Leiterträger aus Siliziumcarbid den Heizleiter aus Kohlenstoff aufnimmt, wird der Heizleiter aus Kohlenstoff von dem Leiterträger mechanisch stabilisiert. Der Heizleiter kann dann vergleichsweise dünn oder auch in einer nahezu beliebigen Form ausgebildet werden, die nicht mehr an eine Festigkeitseigenschaften des Heizleiters berücksichtigende Form gebunden sein muss. Das Widerstandsheizelement kann insbesondere mit dem erfindungsgemäßen Verfahren ausgebildet werden. Zu weiteren vorteilhaften Eigenschaften des Widerstandsheizelements wird auf die Vorteilsbeschreibung des erfindungsgemäßen Verfahrens verwiesen.

Das Widerstandsheizelement kann mit einem Stoffgradienten zwischen dem Kohlenstoff des Heizleiters und dem Siliziumcarbid des Leiterträgers ausgebildet sein. Zwischen dem Heizleiter und dem Leiterträger ist demnach eine Zone ausgebildet, die sowohl Kohlenstoff als auch Siliziumcarbid enthält. Diese Zone entsteht durch Diffusion von dem Material des Heizleiters in das Material des Leiterträgers und umgekehrt während einer Pyrolyse. Besonders vorteilhaft ist es, wenn die Zone vergleichsweise dünn ausgebildet ist.

Der Heizleiter kann in dem Leiterträger eingebettet, vorzugsweise von dem Leiterträger umschlossen sein. Durch diese Ausgestaltung des Widerstandsheizelements kann der Heizleiter besonders gut gegen Risse oder einen Bruch geschützt werden. Weiter kann bei einem Betrieb des Widerstandsheizelements der Leiterträger von dem Heizleiter mit erwärmt werden, sodass ein besonders homogenes Glühbild und damit eine gute Wärmeverteilung erzielbar ist.

Auch können elektrische Anschlussflächen des Heizleiters an dem Leiterträger ausgebildet sein. Die elektrischen Anschlussflächen können aus dem Leiterträger heraustreten bzw. in einer Ebene mit einer Oberfläche des Leiterträgers ausgebildet sein, sodass keine Vorsprünge oder Absätze in der Oberfläche vorhanden sind. Das Widerstandsheizelement kann auch im Bereich der Anschlussflächen mittels Flammspritzen beschichtet sein. Durch thermisches Spritzen von pulverförmigem Aluminium können die Anschlussflächen somit einer elektrisch gut kontaktierbaren Aluminiumschicht versehen sein. Aluminium kann mittels Flammspritzen gut verarbeitet werden und schmilzt während des Betriebs des Widerstandsheizelements von diesem nicht ab.

Das Widerstandsheizelement kann mit einem runden Rohrquerschnitt und einem wendelförmigen Heizleiter ausgebildet sein. Der wendelförmige Heizleiter kann dabei in Art einer Helix oder einer Doppelhelix ausgebildet sein, wobei an einem Ende des Heizleiters Anschlussflächen angeordnet sein können. Das Widerstandsheizelement kann dann einen Formkörper in Art eines Rohrs mit gleichem Durchmesser und gleicher Wandstärke ausbilden. Eine Ausbildung von Luftspalte zur elektrischen Trennung der wendelförmigen Heizleiterbahnen ist dann nicht mehr erforderlich, Luftspalte können jedoch prinzipiell auch vorhanden sein.

Weitere vorteilhafte Ausführungsformen eines Widerstandsheizelements ergeben sich aus den Merkmalsbeschreibungen der auf den Verfahrensanspruch 1 rückbezogenen Unteransprüche.

Im Folgenden wird die Erfindung unter Bezugnahme auf die beigefügten Zeichnungen näher erläutert.

### Es zeigen:

- **Fig. 1**: eine Seitenansicht eines Widerstandsheizelements;
- **Fig. 2**: eine perspektivische Ansicht eines Heizleiters des Widerstandsheizelements;
- **Fig. 3**: eine Teilschnittansicht des Widerstandsheizelements aus **Fig. 1****.**

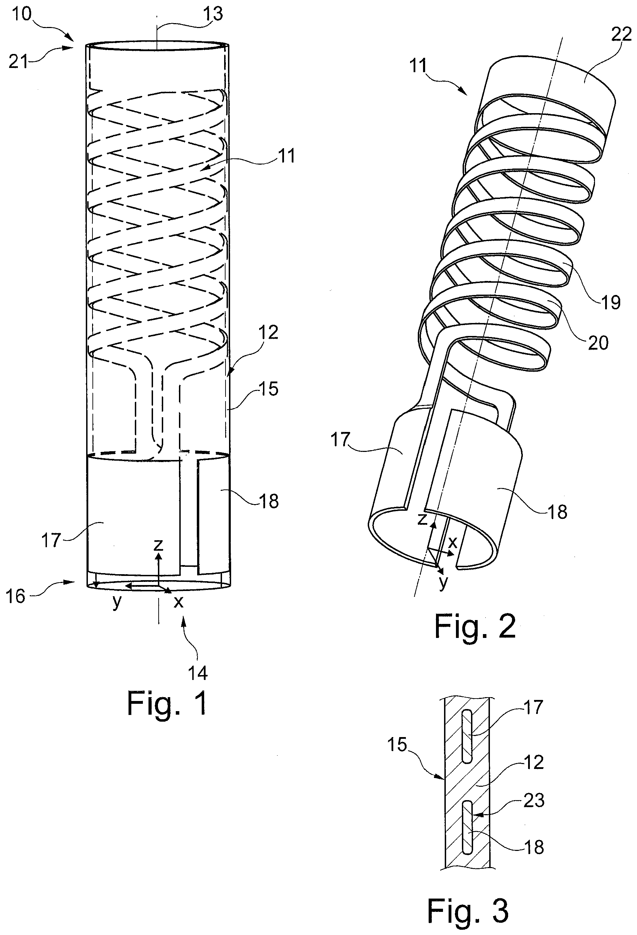

Eine Zusammenschau der **Fig. 1** bis **3** zeigt ein Hochtemperaturbauteil bzw. ein Widerstandsheizelement 10, welches einstückig ausgebildet ist und aus einem Heizleiter und einem Leiterträger 12 besteht. Das Widerstandsheizelement 10 weist einen bezogen auf eine Längsachse 13 rohrförmigen bzw. runden, kreisförmigen Querschnitt 14 auf. Eine Rohrwandung 15 des Widerstandsheizelements 10 ist vergleichsweise dünn ausgebildet. Weiter sind im Bereich eines unteren Endes 16 des Widerstandsheizelements 10 zwei Anschlussflächen 17 und 18 zum Anschluss des Widerstandsheizelements 10 an Anschlusskontakte einer hier nicht dargestellten Anschlussvorrichtung eines DSC-Ofens ausgebildet.

Wie aus der **Fig. 2** hervorgeht, ist der hier alleine dargestellte Heizleiter 11 mit spiralförmigen Heizleiterbahnen 19 und 20, die innerhalb der Rohrwandung 15 verlaufen, ausgebildet. Die Heizleiterbahnen 19 und 20 verlaufen von den Anschlussflächen 17 bzw. 18 in Längsrichtung bis hin zu einem oberen Ende 21 des Widerstandselements 10 und treffen dort in Form eines Rings 22 des Heizleiters 11 zusammen.

Die **Fig. 3** zeigt eine Teilschnittansicht durch die Rohrwandung 15 entlang der Längsachse 13, wobei hier ersichtlich ist, dass die Heizleiterbahnen 19 und 20 in der Rohrwandung 15 bzw. innerhalb dieser, und damit innerhalb des Leiterträgers 12 verlaufen. Der Heizleiter 11 ist insbesondere aus einer Materialmischung eines Matrixmaterials mit einem Kohlenstoffmaterial und der Leiterträger 12 aus einer weiteren Materialmischung des Matrixmaterials mit einem Siliziummaterial ausgebildet, wobei als Matrixmaterial ein Thermoplast verwendet und ein Grünkörper mittels eines additiven Fertigungsverfahrens aus der Materialmischung und gleichzeitig der weiteren Materialmischung ausgebildet und nachfolgend mittels einer Pyrolyse zu dem Widerstandsheizelement 10 ausgebildet wird. Der Heizleiter 11 des Widerstandselements 10 besteht so im Wesentlichen aus Kohlenstoff und der Leiterträger 12 aus Siliziumcarbid. Innerhalb eines sehr schmalen Grenzbereichs 23 zwischen dem Heizleiter 11 und dem Leiterträger 12 kann aufgrund der Pyrolyse der Materialmischung und der weiteren Materialmischung ein Stoffgradient ausgebildet sein. Weiter ist das Widerstandsheizelement 10 mit einer hier nicht sichtbaren Siliziumcarbidschicht, welche im Rahmen eines CVD-Beschichtungsverfahrens aufgebracht wurde, versehen.

## Patentansprüche

1. Verfahren zur Herstellung eines Widerstandsheizelementes (10),
wobei ein formstabiler Grünkörper des Widerstandsheizelementes (10) aus einem Matrixmaterial ausgebildet wird,
wobei als Matrixmaterial ein Thermoplast verwendet wird, wobei das Widerstandsheizelement (10) einstückig und mit einem Heizleiter (11) und mit einem den Heizleiter (11) aufnehmenden elektrisch nichtleitenden Leiterträger (12) ausgebildet wird, wobei der Heizleiter (11) aus einer Materialmischung des Matrixmaterials mit einem
Kohlenstoffmaterial und der Leiterträger (12) aus einer weiteren Materialmischung des Matrixmaterials mit einem Siliziummaterial ausgebildet wird, und wobei der Grünkörper durch ein additiven Fertigungsverfahren aus der Materialmischung und gleichzeitig der weiteren Materialmischung ausgebildet und nachfolgend mittels einer Pyrolyse zu dem Widerstandsheizelement (10) ausgebildet wird.

2. Verfahren nach Anspruch 1,
**dadurch gekennzeichnet,**
**dass** zur Ausbildung des Leiterträgers (12) eine weitere Materialmischung des Matrixmaterials mit einem Siliziummaterial verwendet wird.

3. Verfahren nach Anspruch 2,
**dadurch gekennzeichnet,**
**dass** der Grünkörper mit der in der weiteren Materialmischung eingebetteten Materialmischung ausgebildet wird.

4. Verfahren nach Anspruch 2 oder 3,
**dadurch gekennzeichnet,**
**dass** die weitere Materialmischung mit einer stöchiometrischen Mischung von Matrixmaterial und Siliziummaterial verwendet wird, wobei bei der Pyrolyse aus der weiteren Materialmischung Siliziumcarbid gebildet wird.

5. Verfahren nach einem der Ansprüche 2 bis 4,
**dadurch gekennzeichnet,**
**dass** mittels der Pyrolyse die Materialmischung des Heizleiters (11) in Kohlenstoff und die weitere Materialmischung des Leiterträgers (12) in Siliziumcarbid umgewandelt werden.

6. Verfahren nach einem der Ansprüche 2 bis 5,
**dadurch gekennzeichnet,**
**dass** als Siliziummaterial Siliziumfasern oder Siliziumpartikel verwendet werden.

7. Verfahren nach einem der vorangehenden Ansprüche,
**dadurch gekennzeichnet,**
**dass** als Kohlenstoffmaterial Kohlenstofffasern, Ruß, Graphit, Graphen und/oder Kohlenstoffnanoröhren verwendet werden.

8. Verfahren nach Anspruch 6 oder 7,
**dadurch gekennzeichnet,**
**dass** die Fasern, vorzugsweise Kurzschnittfasern zusammen mit dem Matrixmaterial aus einer Düse ausgegeben und räumlich angeordnet werden.

9. Verfahren nach einem der Ansprüche 6 bis 8,
**dadurch gekennzeichnet,**
**dass** das Widerstandsheizelement (10) mit einem Faseranteil von 10 Vol.% bis 60 Vol.%, vorzugsweise von bis zu 35 Vol.%, ausgebildet wird.

10. Verfahren nach einem der vorangehenden Ansprüche,
**dadurch gekennzeichnet,**
**dass** der Grünkörper mittels Schmelzschichtung (FDM, Fused Deposition Modeling) ausgebildet wird.

11. Verfahren nach einem der vorangehenden Ansprüche,
**dadurch gekennzeichnet,**
**dass** als Matrixmaterial Polyetherimid (PEI), Polyetheretherketon (PEEK), Polysulfon (PSU) oder Polyphenylensulfon (PPSU) verwendet wird.

12. Verfahren nach einem der vorangehenden Ansprüche,
**dadurch gekennzeichnet,**
**dass** nach der Pyrolyse eine CVD-Beschichtung des Widerstandsheizelementes (10) mit Siliziumcarbid erfolgt.

13. Verfahren nach einem der vorangehenden Ansprüche,
**dadurch gekennzeichnet,**
**dass** nach der Pyrolyse eine Hochtemperaturbehandlung des Widerstandsheizelementes (10) erfolgt.

14. Widerstandsheizelement (10), das nach dem Verfahren gemäß einem der Ansprüche 1 bis 13 hergestellt ist.

15. Widerstandsheizelement nach Anspruch 14,
**dadurch gekennzeichnet,**
**dass** das Widerstandsheizelement (10) mit einem Stoffgradienten zwischen dem Kohlenstoff des Heizleiters (11) und dem Siliziumcarbid des Leiterträgers (12) ausgebildet ist.

16. Widerstandsheizelement nach Anspruch 14 oder 15,
**dadurch gekennzeichnet,**
**dass** der Heizleiter (11) in dem Leiterträger (12) eingebettet, vorzugsweise von dem Leiterträger (12) umschlossenen ist.

17. Widerstandsheizelement nach einem der Ansprüche 14 bis 16,
**dadurch gekennzeichnet,**
**dass** elektrische Anschlussflächen (17, 18) des Heizleiters (11) an dem Leiterträger (12) ausgebildet sind.

18. Widerstandsheizelement nach einem der Ansprüche 14 bis 17,
**dadurch gekennzeichnet,**
**dass** das Widerstandsheizelement (10) mit einem runden Rohrquerschnitt (14) und einem wendelförmigen Heizleiter (11) ausgebildet ist.

## Claims

1. A method for producing a resistance heating element (10), a dimensionally stable green body of the resistance heating element (10) being formed from a matrix material, a thermoplastic being used as the matrix material, the resistance heating element (10) being formed in one piece and realized with a heating conductor (11) and with an electrically non-conductive conductor support (12) accommodating the heating conductor (11), a material mixture of the matrix material with a carbon material being used to form the heating conductor (11), and another material mixture of the matrix material with a silicon material being used to form the conductor support (12), the green body being formed from the material mixture and simultaneously the other material mixture by additive manufacturing and being subsequently turned into the resistance heating element (10) by pyrolysis.

2. The method according to claim 1,
**characterized in that**
another material mixture of the matrix material with a silicon material is used to form the conductor support (12).

3. The method according to claim 2,
**characterized in that**
the green body is realized with the material mixture embedded in the other material mixture.

4. The method according to claim 2 or 3,
**characterized in that**
the other material mixture is used with a stoichiometric mixture of matrix material and silicon material, silicon carbide being formed from the other material mixture during pyrolysis.

5. The method according to any one of claims 2 to 4,
**characterized in that**
the pyrolysis converts the material mixture of the heating conductor (11) into carbon and the other material mixture of the conductor support (12) into silicon carbide.

6. The method according to any one of claims 2 to 5,
**characterized in that**
silicon fibers or silicon particles are used as the silicon material.

7. The method according to any one of the preceding claims,
**characterized in that**
carbon fibers, carbon black, graphite, graphene and/or carbon nanotubes are used as the carbon material.

8. The method according to claim 6 or 7,
**characterized in that**
the fibers, preferably short cut fibers, are discharged from a nozzle together with the matrix material and are spatially arranged.

9. The method according to any one of claims 6 to 8,
**characterized in that**
the resistance heating element (10) is realized with a fiber content of 10 vol% to 60 vol%, preferably of up to 35 vol%.

10. The method according to any one of the preceding claims,
**characterized in that**
the green body is formed by fused deposition modeling (FDM).

11. The method according to any one of the preceding claims,
**characterized in that**
polyetherimide (PEI), polyether ether ketone (PEEK), polysulfone (PSU) or polyphenylene sulfone (PPSU) is used as the matrix material.

12. The method according to any one of the preceding claims,
**characterized in that**
the resistance heating element (10) is CVD-coated with silicon carbide after pyrolysis.

13. The method according to any one of the preceding claims,
**characterized in that**
a high-temperature treatment of the resistance heating element (10) is carried out after pyrolysis.

14. A resistance heating element (10) produced as per the method according to any one of claims 1 to 13.

15. The resistance heating element according to claim 14,
**characterized in that**
the resistance heating element (10) is realized with a concentration gradient between the carbon of the heating conductor (11) and the silicon carbide of the conductor support (12).

16. The resistance heating element according to claim 14 or 15,
**characterized in that**
the heating conductor (11) is embedded in the conductor support (12), preferably enclosed by the conductor support (12).

17. The resistance heating element according to any one of claims 14 to 16,
**characterized in that**
electrical terminal pads (17, 18) of the heating conductor (11) are formed on the conductor support (12).

18. The resistance heating element according to any one of claims 14 to 17,
**characterized in that**
the resistance heating element (10) is realized with a round tubular cross section (14) and a helical heating conductor (11).

## Revendications

1. Procédé de fabrication d'un élément chauffant à résistance (10), un corps vert à forme stable de l'élément chauffant à résistance (10) étant formé à partir d'un matériau matriciel, un thermoplastique étant utilisé comme matériau matriciel, l'élément chauffant à résistance (10) étant formé d'un seul tenant et réalisé avec un conducteur chauffant (11) et avec un support de conducteur (12) électriquement non conducteur logeant le conducteur chauffant (11), le conducteur chauffant (11) étant formé à partir d'un mélange de matériaux composé du matériau matriciel et d'un matériau à base de carbone et le support de conducteur (12) étant formé à partir d'un autre mélange de matériaux composé du matériau matriciel et d'un matériau à base de silicium, le corps vert étant formé à partir du mélange de matériaux et simultanément de l'autre mélange de matériaux par fabrication additive et puis transformé en élément chauffant à résistance (10) par pyrolyse.

2. Procédé selon la revendication 1,
**caractérisé en ce**
**qu'**un autre mélange de matériaux composé du matériau matriciel et d'un matériau à base de silicium est utilisé pour former le support de conducteur (12).

3. Procédé selon la revendication 2,
**caractérisé en ce que**
le corps vert est réalisé avec le mélange de matériaux encastré dans l'autre mélange de matériaux.

4. Procédé selon la revendication 2 ou 3,
**caractérisé en ce que**
l'autre mélange de matériaux est utilisé avec un mélange stœchiométrique du matériau matriciel et du matériau à base de silicium, du carbure de silicium étant formé à partir de l'autre mélange de matériaux pendant la pyrolyse.

5. Procédé selon l'une quelconque des revendications 2 à 4,
**caractérisé en ce que**
la pyrolyse transforme le mélange de matériaux du conducteur chauffant (11) en carbone et l'autre mélange de matériaux du support de conducteur (12) en carbure de silicium.

6. Procédé selon l'une quelconque des revendications 2 à 5,
**caractérisé en ce que**
des fibres de silicium ou des particules de silicium sont utilisées comme matériau à base de silicium.

7. Procédé selon l'une quelconque des revendications précédentes,
**caractérisé en ce que**
des fibres de carbone, du noir de carbone, du graphite, du graphène et/ou des nanotubes de carbone sont utilisés comme matériau à base de carbone.

8. Procédé selon la revendication 6 ou 7,
**caractérisé en ce que**
les fibres, de préférence des fibres coupées courtes, sont éjectées d'une buse conjointement avec le matériau matriciel et sont disposées dans l'espace.

9. Procédé selon l'une quelconque des revendications 6 à 8,
**caractérisé en ce que**
l'élément chauffant à résistance (10) est réalisé avec une teneur en fibres de 10 % en volume à 60 % en volume, de préférence allant jusqu'à 35 % en volume.

10. Procédé selon l'une quelconque des revendications précédentes,
**caractérisé en ce que**
le corps vert est formé par dépôt de fil fondu (DFF).

11. Procédé selon l'une quelconque des revendications précédentes,
**caractérisé en ce que**
du polyétherimide (PEI), du polyétheréthercétone (PEEK), du polysulfone (PSU) ou du polyphénylène sulfone (PPSU) est utilisé comme matériau matriciel.

12. Procédé selon l'une quelconque des revendications précédentes,
**caractérisé en ce que**
l'élément chauffant à résistance (10) est revêtu de carbure de silicium par dépôt chimique en phase vapeur (CVD) après la pyrolyse.

13. Procédé selon l'une quelconque des revendications précédentes,
**caractérisé en ce**
**qu'**un traitement à haute température de l'élément chauffant à résistance (10) est effectué après la pyrolyse.

14. Élément chauffant à résistance (10) fabriqué conformément au procédé selon l'une quelconque des revendications 1 à 13.

15. Élément chauffant à résistance selon la revendication 14,
**caractérisé en ce que**
l'élément chauffant à résistance (10) est réalisé avec un gradient de concentration entre le carbone du conducteur chauffant (11) et le carbure de silicium du support de conducteur (12).

16. Élément chauffant à résistance selon la revendication 14 ou 15,
**caractérisé en ce que**
le conducteur chauffant (11) est encastré dans le support de conducteur (12), de préférence enfermé par le support de conducteur (12).

17. Élément chauffant à résistance selon l'une quelconque des revendications 14 à 16,
**caractérisé en ce que**
des surfaces de borne (17, 18) électriques du conducteur chauffant (11) sont formées sur le support de conducteur (12).

18. Élément chauffant à résistance selon l'une quelconque des revendications 14 à 17,
**caractérisé en ce que**
l'élément chauffant à résistance (10) est réalisé avec une section transversale tubulaire (14) ronde et un conducteur chauffant (11) hélicoïdal.
